# EUROPÄISCHE PATENTANMELDUNG

(11) **EP 4 601 198 A1**
(43) Veröffentlichungstag der Anmeldung: **13.08.2025**
(21) Anmeldenummer: 24157108.2
(22) Anmeldetag: 12.02.2024
(51) Int. Cl.: H03K 19/17748, G01R 31/3185, G06F 30/331, G06F 30/34

(54) **PROGRAMMIERBARE GATTERANORDNUNG UND VERFAHREN ZUM ERZEUGEN VON KONFIGURATIONSDATEN ZUR PROGRAMMIERUNG EINER GATTERANORDNUNG**

(71) Anmelder: dSPACE GmbH, 33102 Paderborn (DE)
(72) Erfinder: Kalte, Heiko, 33102 Paderborn (DE); Lubeley, Dominik, 33415 Verl (DE)

(57) **Zusammenfassung**

Die Anmeldung betrifft eine programmierbare Gatteranordnung (FPGA), die eingerichtet ist, eine Funktion (FKT) auszuführen und bei der Ausführung der Funktion (FKT) zumindest ein Signal (SIG) durch zumindest einen Funktionsteil (FT) der Funktion (FKT) zu verwenden, wobei die Gatteranordnung (FPGA) zumindest ein Erfassungselement (EE) aufweist, das dazu eingerichtet ist, unter Verwendung einer Änderung des Signals (SIG) zu ermitteln, ob der zumindest eine Funktionsteil (FT) bei der Ausführung der Funktion (FKT) auf der Gatteranordnung (FPGA) ausgeführt wird, und zumindest einen von der Ermittlung abhängigen Erfassungswert (EW) bereitzustellen.

Die Anmeldung betrifft weiter eine Rechneranordnung (10), welche eine solche Gatteranordnung (FPGA) aufweist, eine Verwendung einer solchen Rechneranordnung (10), eine Testeinrichtung, welche eine solche Rechneranordnung (10) aufweist, sowie ein Verfahren zum Erzeugen von Konfigurationsdaten (72) zur Programmierung einer solchen Gatteranordnung (FPGA).

## Beschreibung

### Technisches Gebiet

Die Anmeldung betrifft eine programmierbare Gatteranordnung, eine Rechneranordnung, welche die Gatteranordnung aufweist, eine Verwendung der Rechneranordnung sowie eine Testeinrichtung zum Testen eines Steuergeräts. Die Anmeldung betrifft weiter ein Verfahren zum Erzeugen von Konfigurationsdaten zur Programmierung einer Gatteranordnung.

### Hintergrund

Geräte zur Ausführung von Steuerungs- und/oder Regelungsaufgaben in Fahrzeugen werden auch als Steuergeräte bezeichnet. Steuergeräte in Fahrzeugen, insbesondere Kraftfahrzeugen, können eine Recheneinheit, Speicher, Schnittstellen und evtl. weitere Komponenten, aufweisen, die für die Verarbeitung von Eingangssignalen mit Eingangsdaten in das Steuergerät und die Erzeugung von Steuersignalen mit Ausgangsdaten erforderlich sind. Die Schnittstellen dienen zur Aufnahme der Eingangssignale bzw. Abgabe der Steuersignale.

In einer Testeinrichtung ist es möglich, Entwicklungsstände des Steuergerätes oder seiner Software in einer emulierten Umgebung zu testen. Solche Testumgebungen können auch Hardware-in-the-Loop-Simulatoren (HILs) aufweisen. Mittels der Hardware-in-the-Loop-Simulatoren kann eine Arbeitsumgebung des Steuergeräts (ECU, Electronic Control Unit) emuliert werden. Die Testumgebung wird eingesetzt, um Steuergeräte in einer weitgehend virtuellen Umgebung gefahrlos und unter reproduzierbaren Bedingungen zu entwickeln und zu testen.

Die Testumgebung kann befehlsbasiert arbeitende Prozessoren und/oder programmierbare Gatteranordnungen aufweisen. Eine programmierbare Gatteranordnung zeichnet sich im Allgemeinen durch eine Vielzahl logischer Einheiten aus, jede ein oder mehrere Logikgatter umfassend, deren Funktionalität und Verschaltung untereinander durch Programmierung änderbar ist. Die programmierbare Gatteranordnung, insbesondere ein Field Programmable Gate Array (FPGA), kann neben den logischen Einheiten auch andere Ressourcen aufweisen, die wie die logischen Einheiten verschaltbar und in die Programmlogik einbindbar sind, beispielsweise RAM-Blöcke, Register oder integrierte Signalprozessoren.

Ein Vorteil programmierbarer Gatteranordnungen ist ihre Fähigkeit, auf einer einzigen Recheneinheit viele Rechen- oder Logikoperation parallel durchzuführen. FPGAs sind Beispiele für leistungsfähige programmierbare Gatteranordnungen. Weitere Beispiele sind CPLDs (Complex Programmable Logic Devices) und PALs (Programmable Array Logics).

In DE102020116872A1 wird ein Verfahren zur Programmierung einer programmierbaren Gatteranordnung in einem verteilten Computersystem beschrieben.

### Übersicht

Eine programmierbare Gatteranordnung ist eingerichtet, eine Funktion auszuführen und bei der Ausführung der Funktion zumindest ein Signal durch zumindest einen Funktionsteil der Funktion zu verwenden. Die Gatteranordnung weist zumindest ein Erfassungselement auf, das eingerichtet ist, unter Verwendung einer Änderung des Signals zu ermitteln, ob der zumindest eine Funktionsteil bei der Ausführung der Funktion auf der Gatteranordnung ausgeführt wird. Das Erfassungselement ist weiter eingerichtet zumindest einen von der Ermittlung abhängigen Erfassungswert bereitzustellen.

Durch eine solche Gatteranordnung wird eine Analyse der Ausführung der Funktion der programmierbaren Gatteranordnung ermöglicht. Insbesondere kann eine Abdeckung der Funktion bei der Ausführung ermittelt und analysiert werden. Die Abdeckung betrifft dabei die ausgeführten, also zumindest teilweise durchlaufenen, Funktionsteile der Funktion.

Eine Rechneranordnung weist die genannte Gatteranordnung sowie eine Prozessoreinheit auf. Die Prozessoreinheit ist dazu eingerichtet, den zumindest einen Erfassungswert zu zumindest einem Ergebniswert auszuwerten.

Es wird vorgeschlagen, die Rechneranordnung zum Testen eines Steuergeräts oder zum Simulieren eines Steuergeräts zu verwenden.

Eine Testeinrichtung zum Testen eines Steuergeräts weist die genannte Rechneranordnung auf. Dabei kann die Gatteranordnung zum Testen des Steuergeräts über einen Datenaustausch mit dem Steuergerät dienen und/oder das Steuergerät kann mittels der Gatteranordnung simulierbar sein.

Bei einem Verfahren zum Erzeugen von Konfigurationsdaten zur Programmierung einer Gatteranordnung aus einem Modell gibt das Modell eine durch die Gatteranordnung auszuführende Funktion vor. Bei der Ausführung der Funktion auf der Gatteranordnung wird zumindest ein Signal durch zumindest einen Funktionsteil der Funktion verwendet. Das Verfahren weist auf:
- Empfangen von Eingabedaten zu dem Modell,
- Automatisiertes Platzieren zumindest eines Erfassungselements in dem Modell, wobei das zumindest eine Erfassungselement dazu eingerichtet ist, bei der Ausführung der Funktion auf der Gatteranordnung unter Verwendung einer Änderung des Signals zu ermitteln, ob der zumindest eine Funktionsteil ausgeführt wird und zumindest einen von der Ermittlung abhängigen Erfassungswert bereitzustellen,
- Erzeugen der Konfigurationsdaten zur Programmierung der Gatteranordnung aus dem Modell.

Durch die beschriebene Gatteranordnung, deren Verwendung und das beschriebene Verfahren ist es möglich, die Ausführung von Funktionsteilen bei der Ausführung der Funktion auf der Gatteranordnung zu analysieren. Zum Beispiel wird ermöglicht festzustellen, ob bei der Ausführung der Funktion auf der Gatteranordnung bestimmte Funktionsteile ausgeführt wurden oder nicht. Damit kann eine Ermittlung einer sogenannte Abdeckung (engl. Coverage) für eine solche Gatteranordnung realisiert werden. Die Abdeckung kann zum Beispiel beim Testen der Gatteranordnung als sogenannte Test Coverage angeben, ob beispielsweise bei einem Test ein jeweiliger Funktionsteil der Funktion der Gatteranordnung auch tatsächlich ausgeführt wurde. Dies kann dann bspw. zu Dokumentationszwecken abgespeichert werden, um zu belegen, dass die jeweilige Funktion auch in einem Test geprüft wurde. Es kann aber auch dazu verwendet werden, die in einem ersten Test noch nicht ausgeführten Funktionsteile in einem weiteren Test auszuführen.

Eine solche Analyse der Gatteranordnung wird durch die beschriebene Gatteranordnung, deren Verwendung und das beschriebene Verfahren in Echtzeit ermöglicht, da das zumindest eine Erfassungselement auf der Gatteranordnung vorgesehen ist und den zumindest einen Erfassungswert beim Ausführen der Funktion in Echtzeit zur Verfügung stellen kann. Die Erfassung der Abdeckung kann also zur Laufzeit erfolgen. Dies ist viel schneller, als wenn simulationsbasierte Verfahren zur Abdeckungsanalyse verwendet werden würden, die nicht auf der Gatteranordnung laufen. Eine entsprechende Beschleunigung ergibt sich für die Rechneranordnung. Ebenso gilt das für die Testeinrichtung zum Testen eines Steuergeräts, die diese Rechneranordnung aufweist.

Das Verfahren zum Erzeugen von Konfigurationsdaten zur Programmierung einer solchen Gatteranordnung aus einem Modell ermöglicht die Erstellung einer solcher Gatteranordnung, die die oben genannte Analyse ermöglicht, um festzustellen welche Funktionsteile der Funktion, die durch die Gatteranordnung ausgeführt wird, durchlaufen wurden. Das Modell definiert dabei die durch die Gatteranordnung ausführbare Funktion. Das Verfahren ermöglicht insbesondere die automatische Platzierung des zumindest einen Erfassungselementes in dem Modell. Die Platzierung kann dabei zum Beispiel auf einer graphischen Benutzeroberfläche visualisiert werden. Die automatische Platzierung kann durch die Eingabe eines Nutzers gestartet werden. Dabei kann der Nutzer z. B. über Auswahlmenüs eine Wahl treffen, welche dann automatisiert zur Platzierung des zumindest einen Erfassungselementes führt.

Beispiele für programmierbare Gatteranordnungen sind in DE102020116872A1 beschrieben. Solche programmierbaren Gatteranordnungen können zum Beispiel auch für diese Anmeldung Verwendung finden.

Unter einer Funktion ist je nach Aufgabe der Gatteranordnung eine Aktion zu verstehen, die beispielsweise einen Batteriestrom simuliert oder das Ausgabesignal eines Stromsensors oder auch ein Steuersignal. Dabei wird bei der Ausführung dieser Funktion zumindest ein Signal durch zumindest einen Funktionsteil der Funktion verwendet. D. h. das Signal wird zumindest in einem Teil der Funktion eingesetzt. In einer Gatteranordnung kann optional mehr als eine Funktion implementiert sein. Die Gatteranordnung kann zum Beispiel einen Elektromotor und/oder eine Leistungselektronik, die den Elektromotor steuert und treibt, und/oder eine Batterie simulieren. Alternativ ist es möglich, dass die Gatteranordnung ein Steuergerät simuliert, das die Batterie und/oder die Leistungselektronik steuert. Entsprechend sind dann die dafür notwendigen Funktionen in der Gatteranordnung verwirklicht.

Weiterhin ist ein Erfassungselement vorgesehen, das dazu eingerichtet ist, unter Verwendung einer Änderung des Signals zu ermitteln, ob der zumindest eine Funktionsteil bei der Ausführung der wenigstens einen Funktion auf der Gatteranordnung ausgeführt wird. In Abhängigkeit davon wird der Erfassungswert bereitgestellt. Über den Erfassungswert wird demnach transparent, ob ein jeweiliger Funktionsteil bei der Ausführung der Funktion auch ausgeführt wurde. Damit ist dann die sogenannte Abdeckung (engl. Coverage) der Funktion nachvollziehbar. Der Erfassungswert kann dabei ein logischer z. B. binärer Wert sein oder auch eine Zahl, z. B. natürliche Zahl, oder auch ein kontinuierlicher Wert. Das Erfassungselement umfasst dabei eine Schnittstelle, die den Abgriff des Erfassungswerts ermöglicht. Das Erfassungselement weist dafür Mittel auf, die es ermöglichen, eine Änderung des Signals zu ermitteln und damit, ob der Funktionsteil ausgeführt wird. Dies wird dann in dem Erfassungswert, welcher von der Signaländerung abhängt, bereitgestellt.

Der Erfassungswert kann in einem weiteren Schritt zu einem Ergebniswert ausgewertet werden. Dies kann zum Beispiel in der Gatteranordnung selbst geschehen. Alternativ oder zusätzlich kann die Auswertung auch in einer Prozessoreinheit vorgesehen sein.

Die Rechneranordnung weist die beschriebene programmierbare Gatteranordnung sowie die Prozessoreinheit auf. Die Prozessoreinheit ist vorgesehen, den zumindest einen Erfassungswert zu dem zumindest eine Ergebniswert auszuwerten. Es ist optional auch möglich, dass die Gatteranordnung diese Aufgabe der Auswertung des zumindest einen Erfassungswertes zu dem zumindest einen Ergebniswert selbst übernimmt. Der Ergebniswert kann eine statistische Auswertung mehrerer Erfassungswerte oder davon abgeleiteter Werte aufweisen. Weiterhin ist es möglich, dass mittels des Erfassungswertes und/oder mittels des Ergebniswertes Zählerwerte über die Laufzeit der Ausführung der Funktion gespeichert werden, um die Gesamtzahl der Änderungen des Signals zu erhalten. Die Auswertung zu dem zumindest einen Ergebniswert kann auch eine Mittelwert- oder Medianbildung umfassen. Auch ein Festhalten von Maximal- und/oder Minimalwerten ist möglich.

Unter dem Steuergerät wird beispielsweise ein Steuergerät in einem Fahrzeug zum Steuern eines elektrischen Antriebs verstanden, so dass das Steuergerät einen Elektromotor, die Leistungselektronik und/oder eine Traktionsbatterie steuert. Ein Steuergerät erhält wenigstens ein Eingabesignal über eine Eingabeschnittstelle und wertet dies aus und erzeugt in Abhängigkeit von dieser Auswertung wenigstens ein Steuersignal, das über eine Ausgangsschnittstelle ausgegeben wird. Das Eingabesignal kann ein Sensorsignal sein, das bspw. eine Gaspedalbetätigung repräsentiert. Auch Ausgangssignale von anderen Steuergeräten können solche Eingabesignale sein.

Die Rechneranordnung kann dabei zum einen zum Testen des Steuergeräts dienen und dabei z. B. die Arbeitsumgebung des Steuergeräts emulieren. Die Rechneranordnung kann dabei Signale der Steuergeräteumgebung an das Steuergerät liefern und entsprechende Signale vom Steuergerät aufnehmen und verarbeiten. Alternativ kann die Rechneranordnung selbst ein solches Steuergerät simulieren, z. B. einen Entwicklungsstand des Steuergerätes oder eine Version der Software, und beispielsweise mit einer Batterie oder einem Elektromotor oder eine Leistungselektronik oder einer Kombination daraus in Verbindung gebracht werden, um zu prüfen, ob die Peripherie des Steuergeräts mit dem simulierten Steuergerät arbeiten kann und/oder um den Entwicklungsstand des Steuergerätes zu prüfen.

Die Rechneranordnung kann daher in einer Testeinrichtung zum Testen dieses Steuergeräts angeordnet sein. Solche Testeinrichtungen werden beispielsweise von Fahrzeugherstellern und Zulieferern genutzt, um die Steuergeräte, bzw. deren Peripherie zu testen. Dabei gibt es einen Datenaustausch mit dem Steuergerät, das entsprechende Schnittstellen dafür aufweist. Dieser Datenaustausch kann beispielsweise über einen Datenbus erfolgen oder auch direkte Datenleitungen. Es ist auch möglich, Daten über Leitungen auszutauschen, über die beispielsweise auch Energie ausgetauscht wird.

Die programmierbare Gatteranordnung wird aus Konfigurationsdaten programmiert, wobei die Konfigurationsdaten aus einem Modell abgeleitet werden. In dem Modell ist die durch die Gatteranordnung auszuführende Funktion vorgegeben. Das Modell kann auch als Systembeschreibung bezeichnet werden. Durch Eingabedaten, die entweder durch einen Nutzer über eine grafische Benutzerschnittstelle eingegeben werden oder die aus einem Speicher geladen werden, wird das Modell, das die Funktion definiert, gebildet.

Die Erfassungselemente werden dann automatisiert platziert, und zwar in dem Modell, um dann über die Erfassungselemente prüfen zu können, ob Funktionsteile bei der Ausführung der Funktion, beispielsweise beim Testen, genutzt wurden oder nicht. Aus dem Modell können die Konfigurationsdaten erzeugt werden, um die Gatteranordnung zu programmieren und damit zu realisieren. Die Konfigurationsdaten können auch als Bitstrom bezeichnet werden.

Es ist vorgesehen, die Gatteranordnung über eine Eingabe eines Modells zu programmieren, wobei das Modell als eine Art Systembeschreibung, die durch die Gatteranordnung ausführbare Funktion vorgibt. Das Erfassungselement ist über das Modell auf der Gatteranordnung programmierbar. Der Ort des Erfassungselementes und ggf. die Orte von mehreren Erfassungselementen im Modell und damit auf der Gatteranordnung können dabei z. B. nach einem vorgegebenen Algorithmus automatisch festgelegt werden.

Darüber hinaus ist es vorgesehen, dass die Gatteranordnung eine Ausleselogik aufweist, die dazu eingerichtet ist, den durch das Erfassungselement bereitgestellten zumindest einen Erfassungswert auszugeben. Die Ausleselogik kann also z. B. den Erfassungswert aus einem Speicher des Erfassungselementes auslesen und weitergeben.

In Ausführungsformen ist die Ausleselogik eingerichtet, den zumindest einen Erfassungswert während der Ausführung der Funktion oder nach Ende der Ausführung der Funktion auszugeben. Damit ist gewährleistet, dass auch während der Ausführung der Funktion, z. B. während des Ablaufs des Tests, beispielsweise der Erfassungswert verfügbar ist, sodass überwacht werden kann, welche Funktionen bzw. Funktionsteile bereits ausgeführt wurden. Alternativ kann nach Ende der Ausführung der Funktion der Erfassungswert ausgegeben werden, sodass dann die Überwachung der Ausführung der Funktion dokumentiert ist. Diese letzte Ausführung erfordert größere Zähler und/oder größere Speicher in dem Erfassungselement.

In Ausführungsformen ist die Ausleselogik eingerichtet, den zumindest einen Erfassungswert über eine Multiplexereinheit über einen Bus auszugeben oder über eine Schieberegisterkette über einen Bus auszugeben. D. h. die Ausleselogik weist eine Multiplexereinheit auf, die es ermöglicht, den Erfassungswert auf einen Bus zu geben, oder die Übertragung wird über eine Schieberegisterkette realisiert. Ein Multiplexer ist ein Gerät, das zwischen verschiedenen Eingabesignalen auswählt und das ausgewählte Eingabesignal dann auf eine Ausgabeschnittstelle, bspw. eine Schnittstelle zu einem Bus, schaltet.

In Ausführungsformen ist die Ausleselogik eingerichtet, den zumindest einen Erfassungswert über eine Konfigurationsschnittstelle über einen Bus auszugeben, wobei die Konfigurationsschnittstelle dazu eingerichtet ist, die Konfigurationsdaten zur Programmierung der Gatteranordnung zu empfangen. Damit kann also über eine solche Konfigurationsschnittstelle ein zusätzlicher Nutzen erzeugt werden, indem sie für die Ausgabe des Erfassungswerts genutzt wird. Die Konfigurationsschnittstelle weist in dieser Ausführungsform also die Ausleselogik auf oder umgekehrt. Es ist ebenfalls möglich, dass die Konfigurationsschnittstelle der Ausleselogik entspricht. Die Ausleselogik der Konfigurationsschnittstelle kann neben dem Empfang der Konfigurationsdaten auch zum Auslesen der Konfigurationsdaten aus der Gatteranordnung ausgebildet sein. Die ausgelesenen Konfigurationsdaten können dabei insbesondere den zumindest einen Erfassungswert aufweisen. Das Auslesen der Konfigurationsdaten umfasst in einer solchen Ausführungsform also das Auslesen des zumindest einen Erfassungswertes.

In einer Ausführungsform kann vorgesehen sein, dass das Erfassungselement zumindest ein Schattenregister zur Aufnahme des zumindest einen Erfassungswerts aufweist. Das Erfassungselement kann damit den zumindest einen Erfassungswert in dem zumindest einen Schattenregister zum Auslesen bereitstellen. Das zumindest eine Schattenregister weist hierfür einen Speicherbereich auf, aus dem der zumindest eine Erfassungswert unabhängig von der ausgeführten Funktion über die Konfigurationsschnittstelle auslesbar ist. Das zumindest eine Schattenregister bewahrt den zumindest einen Erfassungswert auf, da in dem Schattenregister ein Überschreiben bei einem Ausführen der Funktion nicht vorgesehen ist. Daher kann dann aus diesem zumindest einen Schattenregister der Erfassungswert unabhängig von der ausgeführten Funktion ausgelesen werden.

In einer Ausführungsform weist das zumindest eine Erfassungselement zumindest einen Zähler auf, über den eine Anzahl von Änderungen des zumindest einen Signals erfassbar sind, wobei das zumindest eine Erfassungselement dazu eingerichtet ist, unter Verwendung der Anzahl an Änderungen des zumindest einen Signals zu ermitteln, wie oft der zumindest eine Funktionsteil bei der Ausführung der Funktion auf der Gatteranordnung ausgeführt wird, und das Ergebnis als den zumindest ein Erfassungswert bereitzustellen. Über ein solches Erfassungselement lässt sich die Analyse der Abdeckung weiter verbessern, da nicht nur erfassbar ist, ob ein Funktionsteil ausgeführt wurde sondern auch wie oft.

Darüber hinaus ist es vorgesehen, dass das Erfassungselement dazu eingerichtet ist, vorgegebene Bits des zumindest einen Erfassungswerts an das zumindest eine Schattenregister zu übertragen. Hierdurch kann der Speicherbedarf für das Schattenregister reduziert werden.

In einer Ausführungsform ist das zumindest eine Schattenregister zu einer logarithmischen Abspeicherung des zumindest einen Erfassungswerts eingerichtet. Dies ist vor allem bei der Speicherung von Zahlen, z. B. der Anzahl der Ausführungen eines Funktionsteils von Vorteil. Dadurch kann das Schattenregister kleiner ausfallen, denn eine Ungenauigkeit in der Abdeckung kann bei größeren und sehr großen Anzahlen akzeptabel sein.

Alternativ ist es möglich, dass das oder die Schattenregister nicht einen Absolutwert, sondern Durchschnittswerte abspeichert, was jedoch in dem Erfassungselement entsprechende Rechenlogik erfordern kann. Insbesondere kann das zumindest eine Erfassungselement dazu eingerichtet sein, einen Durchschnittswert von mehreren Erfassungswerten bereitzustellen. Durch diese statistische Betrachtung können Ausreißer bei den Erfassungswerten in ihrer Wirkung reduziert werden.

Weiterhin ist es möglich, dass der mindestens eine Ergebniswert, welcher z. B. in der Gatteranordnung und/oder in der Prozessoreinheit ermittelt wird, zumindest eine statistische Auswertung mehrerer Erfassungswerte und/oder mehrere vom zumindest einen Erfassungswert abgeleiteter Werte aufweist. Dies führt zu einer höheren Genauigkeit der Betrachtung.

Weiterhin ist es möglich, dass die Ausleselogik eingerichtet ist, den zumindest einen Erfassungswert an die Prozessoreinheit auszugeben. Dies kann beispielsweise über einen Bus erfolgen oder über eine Punkt-zu-Punkt-Verbindung. Der Prozessor in der Prozessoreinheit kann dann weitere Auswertungen des zumindest einen Erfassungswerts ausführen, um den Ergebniswert zu erzeugen.

In einer Ausführungsform weist die Rechneranordnung eine Eingabe- und Darstellungseinheit auf. Die Eingabe- und Darstellungseinheit ist eingerichtet, den zumindest einen Erfassungswert und/oder den zumindest einen Ergebniswert insbesondere an einen Nutzer auszugeben. Damit wird diese Auswertung für den Nutzer transparent gemacht.

Weiterhin ist es möglich, dass über die Eingabe- und Darstellungseinheit die Eingabe des Modells ermöglicht wird, wobei das zumindest eine Erfassungselement im Modell platziert ist, wobei die Platzierung manuell und/oder automatisch erfolgt. Die Eingabe- und Darstellungseinheit kann dabei z. B. als ein Rechner oder Computer ausgebildet sein, auf welchem Software für die Erstellung des Modells, z. B.

Simulink, ausgeführt wird. Diese Software ermöglicht dann zusätzlich die Generierung und automatische oder manuelle Platzierung der Erfassungselemente.

Darüber hinaus ist es möglich, dass die Eingabe- und Darstellungseinheit dazu eingerichtet ist, in Abhängigkeit von dem zumindest einen Ergebniswert genutzte Funktionsteile der Funktion der Gatteranordnung darzustellen. Damit kann beispielsweise eine grafische Darstellung gewählt werden, die es einem Nutzer ermöglicht, zu sehen, welche Funktionsteile bereits getestet wurden. Hierfür kann die Eingabe- und Darstellungseinheit z. B. als ein Rechner oder Computer ausgebildet sein, welcher einerseits Software für die Erstellung des Modells, z. B. Simulink, und andererseits Software zur Visualisierung der Abdeckung aufweist.

Insbesondere können zur Visualisierung der Abdeckung Listen von Funktionsteilen und/oder Funktionen nach deren Namen und Aktivität angezeigt werden, dabei kann Aktivität bedeuten, wie häufig diese Funktionsteile bzw. Funktionen durchlaufen wurden. Diese Aktivität ist im zeitlichen Verlauf als Diagramm, insbesondere als Balkendiagramm darstellbar. Die Darstellung kann zwei- oder dreidimensional erfolgen. Auch eine sogenannte Activity Map ist darstellbar. D.h. Funktionen oder Funktionsteile, die durchlaufen wurden, werden farblich oder durch Tönungen hervorgehoben. Je häufiger eine Funktion oder ein Funktionsteil durchlaufen wurde, umso intensiver kann die Farbe oder die Tönung sein. Auch kann das Modell auf einer Webseite durchnavigierbar dargestellt sein. Nach einem Test kann auch ein Report erstellt werden, der das Durchlaufen der Funktionen und Funktionsteile dokumentiert. Darin ist insbesondere die Häufigkeit zahlenmäßig oder im Sinne der Activity Map enthalten.

### Figurenliste

Ausführungsbeispiele sind in der Zeichnung dargestellt und werden in der nachfolgenden Beschreibung näher erläutert.

Es zeigen
Figur 1 ein Blockschaltbild eines Ausführungsbeispiels einer Rechneranordnung,
Figur 2 ein Blockschaltbild eines ersten Ausführungsbeispiels eines Modells,
Figur 3 ein Blockschaltbild eines ersten Ausführungsbeispiels eines Erfassungselements,
Figur 4 ein Blockschaltbild eines zweiten Ausführungsbeispiels des Erfassungselements,
Figur 5 ein Blockschaltbild eines zweiten Ausführungsbeispiels des Modells,
Figur 6 ein Blockschaltbild des zweiten Ausführungsbeispiels des Modells,
Figur 7 ein Blockschaltbild eines weiteren Ausführungsbeispiels der Rechneranordnung,
Figur 8 eine grafische Benutzeroberfläche und
Figur 9 ein Flussdiagramm eines Verfahrens zum Erzeugen von Konfigurationsdaten.

Es werden in den Figuren die gleichen Bezugszeichen für gleiche oder ähnliche Elemente verwendet. Die Darstellungen in den Figuren können nicht maßstäblich sein.

### Figurenbeschreibung

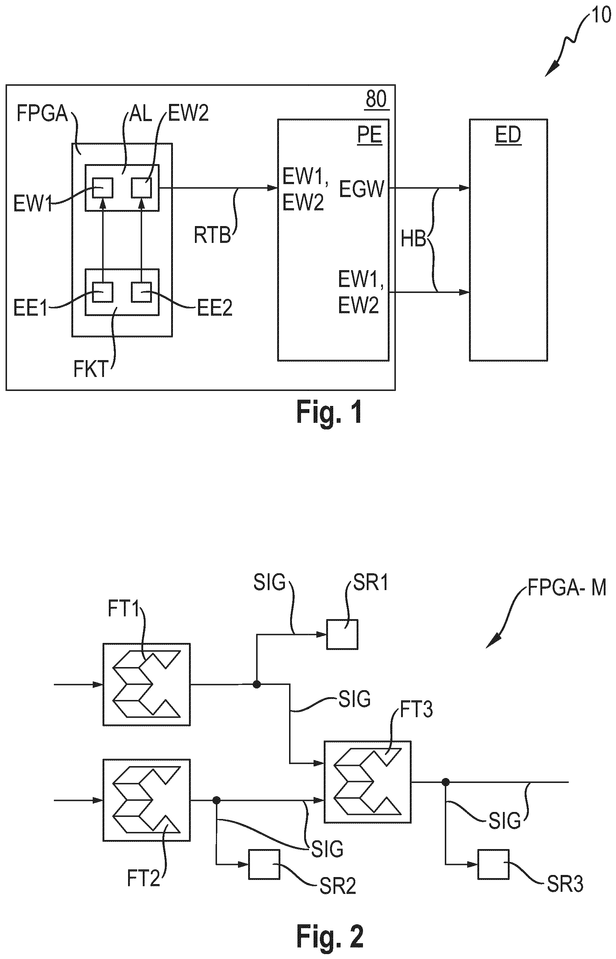

Figur 1 zeigt in einem ersten Blockschaltbild die Rechneranordnung 10. Die Rechneranordnung 10 weist dabei drei Komponenten auf, die miteinander verbunden sind. Die Komponenten sind eine Gatteranordnung FPGA, eine Prozessoreinheit PE und eine Eingabe- und Darstellungseinheit ED. Die Gatteranordnung FPGA ist über einen Echtzeit-Bus RTB zur Datenübertragung an die Prozessoreinheit PE angeschlossen. Die Gatteranordnung FPGA und die Prozessoreinheit PE können insbesondere Teil einer Echtzeitumgebung 80 sein und können beispielsweise gemeinsam auf einem sogenannten Board angeordnet sein. Weiterhin besteht zwischen der Prozessoreinheit PE und der Eingabe- und Darstellungseinheit ED eine Datenverbindung über einen Host-Bus HB. Es ist möglich, dass weiterhin eine direkte Datenverbindung zwischen der Gatteranordnung FPGA und der Eingabe- und Darstellungseinheit ED besteht, oder auch Daten durch die Prozessoreinheit PE lediglich durchgereicht werden.

Sowohl der Echtzeit-Bus RTB als auch der Host-Bus HB können als Datenbusse ausgebildet sein, die Daten seriell oder parallel übertragen. Der Echtzeit-Bus RTB ist dabei ausgebildet, Echtzeitbedingungen einzuhalten.

Die Gatteranordnung FPGA weist eine Funktion FKT mit zwei Erfassungselementen EE1 und EE2 auf. Aus den Erfassungselementen EE1 und EE2 können durch eine Ausleselogik AL Erfassungswerte EW1 und EW2 ausgelesen werden. Die Ausleselogik AL überträgt die Erfassungswerte EW1 und EW2 über den Echtzeit-Bus RTB an die Prozessoreinheit PE, die aus den Erfassungswerten EW1 und EW2 einen Ergebniswert EGW erzeugt. Zu der Erzeugung des Ergebniswerts EGW können beispielsweise statistische Auswertungen der Erfassungswerte EW1, EW2 dienen.

Die Prozessoreinheit PE überträgt die Erfassungswerte EW1 und EW2 und/oder den Ergebniswert EGW über den Host-Bus HB an die Eingabe- und Darstellungseinheit ED. Es ist möglich, dass nur die Erfassungswerte EW1 und EW2 oder nur der Ergebniswert EGW übertragen wird. Es ist weiterhin möglich, dass mehrere Ergebniswerte EGW an die Eingabe- und Darstellungseinheit ED übertragen werden.

In der Eingabe- und Darstellungseinheit ED können dann der Ergebniswert EGW und die Erfassungswerte EW1 und EW2 graphisch dargestellt werden oder auch nur mit ihrem jeweiligen Wert dargestellt werden. Die Darstellung kann z. B. nach Benutzereingaben angepasst werden.

Figur 2 zeigt ein Blockschaltbild eines ersten Ausführungsbeispiels des Modells FPGA-M mit Schattenregistern SR1, SR2, SR3. Die Schattenregister SR1, SR2, SR3 weisen jeweils Speicherbereiche auf oder sind jeweilige Speicherbereiche. In den Schattenregistern SR1, SR2, SR3 kann der jeweilige Wert des Signals SIG während der Ausführung der Funktion der Gatteranordnung FPGA gespeichert und ausgelesen werden. Das Auslesen der Schattenregister SR1, SR2, SR3 ist dabei funktional unabhängig von der Ausführung der Funktion FKT.

Das Modell FPGA-M weist einen ersten Funktionsteil FT1 und eine zweiten Funktionsteil FT2 auf, die jeweils ein Signal SIG ausgeben. Dieses jeweilige Signal SIG wird jeweils in ein jeweiliges Schattenregister SR1 und SR2 abgespeichert, d.h. an jedem Ausgang eines Funktionsteils FT1, FT2 ist ein Schattenregister vorgesehen. Über diese Schattenregister SR1, SR2 kann dann über ein Auslesen der Daten geprüft werden, ob die jeweiligen Funktionsteile FT1, FT2 auch durch das Signal SIG durchlaufen wurden.

Weiterhin werden die jeweiligen Ausgangssignale SIG an einen dritten Funktionsteil FT3 als Eingabesignale eingegeben, wobei auch das Ausgangssignal SIG des dritten Funktionsteils FT3 in ein Schattenregister SR3 abgespeichert wird, aber auch wiederum weitergeführt wird, bspw. in den nächsten Funktionsteil FT.

Die Daten in den Schattenregistern SR1, SR2 und SR3 können dann als Erfassungswerte EW ausgelesen werden. Es ist möglich, dass die Schattenregister SR1, SR2 und SR3 eine logarithmische Abspeicherung ermöglichen. Dies ist eine datensparende Methode zum Abspeichern.

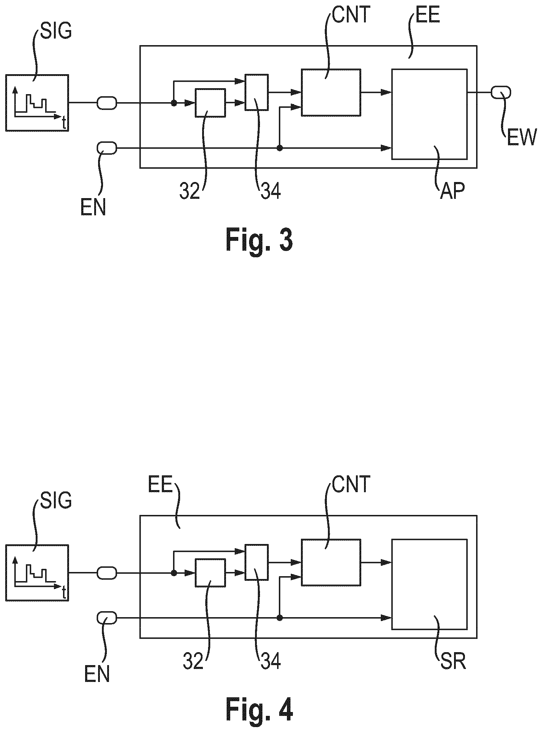

Figur 3 zeigt ein Blockschaltbild eines ersten Ausführungsbeispiels des Erfassungselements EE, das den Erfassungswert EW ausgibt. Das Erfassungselement EE weist mehrere Blöcke der Gatteranordnung FPGA auf.

Das Signal SIG ist das Eingabesignal SIG, das auf den Block 32, der ein Verzögerungsglied darstellt, sowie auf den Block 34, der ein Vergleicher ist, gegeben wird. Da auch das Ausgangssignal des Verzögerungsglieds 32 an einen weiteren Eingang des Vergleiches 34 angeschlossen ist, wird ein Vergleich des Signals SIG mit seinem verzögerten Selbst ausgeführt. Das Ausgangssignal des Vergleichers 34 wird an einen Zähler CNT gegeben. Der Zähler CNT wird über ein Enable-Signal EN an einem weiteren Eingang gesteuert. Dieses Enable-Signal EN geht auch an den Ausgangsport AP, der als ein weiteres Eingangssignal das Ausgangssignal des Zählers CNT erhält. Damit wird gesteuert, dass als Erfassungswert EW ein bestimmter Zählerwert ausgegeben wird. Das Enable-Signal EN schaltet den Zähler CNT und den Ausgangsport AP jeweils frei. Der Erfassungswert EW ist das Ausgangssignal des Erfassungselements EE.

Figur 4 zeigt ein Blockschaltbild eines zweiten Ausführungsbeispiels des Erfassungselements EE, das als jeweilige Eingangssignale das Signal SIG sowie das Enable-Signal EN aufweist. Das Erfassungselement EE weist mehrere Blöcke der Gatteranordnung FPGA auf.

Wiederum wird, wie in Fig. 3, das Signal SIG mit seinem durch das Verzögerungsglied 32 verzögerten Selbst durch den Vergleicher 34 verglichen. Das Ausgangssignal des Vergleichers 34 wird wieder im Zähler CNT gezählt. Das Enable-Signal EN schaltet den Zähler CNT wieder frei. Nunmehr ist der Ausgang des Zählers CNT jedoch an ein Schattenregister SR angeschlossen, an das auch das Enable-Signal EN angeschlossen ist. Aus dem Schattenregister SR ist dann letztlich der Erfassungswert EW durch die Ausleselogik AL, welche z. B. einer Konfigurationsschnittstelle 70 der Gatteranordnung FPGA entsprechen kann, auslesbar.

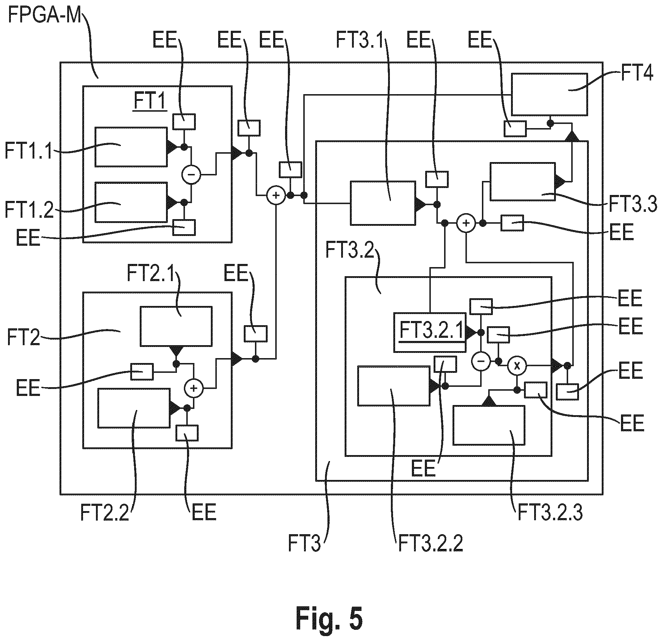

Figur 5 zeigt ein Blockschaltbild eines zweiten Ausführungsbeispiels des Modells FPGA-M mit verschiedenen Erfassungselementen EE, die an den Ausgängen von Funktionen FT1-FT4 und an den Ausgängen von Funktionsteilen FT1.1-FT3.3 platziert sind. Vorliegend sind vier Funktionsteile FT1-4 gezeigt, wobei die Funktion FT4 keine Funktionsteile aufweist. Die Funktionsteile FT1-FT4 bilden gemeinsam die Funktion FKT.

Die Funktion FT1 weist die Teilfunktionen FT1.1 und FT1.2 auf, deren Ausgangssignale voneinander subtrahiert werden, um das Ausgangssignal der Funktion FT1 zu bilden.

Die Funktion FT2 weist ebenfalls zwei Funktionsteile FT2.1 und FT2.2 auf. Die Ausgangssignale dieser Funktionsteile FT2.1 und FT2.2 werden zum Ausgangssignal der Funktion FT2 addiert. Die Ausgangssignale der Funktionen FT1 und FT2 werden ebenfalls zu einem Eingabesignal für die Funktionen FT3 und FT4 addiert. Jedes Ausgangssignal wird durch ein jeweiliges Erfassungselement EE aufgenommen und ist damit überwachbar.

Die Funktion FT3 weist drei Funktionsteile FT3.1, FT3.2 und FT3.3 auf, wobei der Funktionsteil FT3.2 in drei weitere Funktionsteile FT3.2.1, FT3.2.2 und FT3.2.3 aufgeteilt ist.

Das Eingabesignal, das aus den Ausgangssignalen der Funktionen FT1 und FT2 gebildet wird, geht in den Funktionsteil FT3.1 ein. Das Ausgangssignal des Funktionsteils FT3.1 wird einerseits zu dem Ausgangssignal des Funktionsteils FT3.2 addiert und andererseits geht es als Eingangssignal in den Funktionsteil FT3.2 ein. Dort wird es von dem Funktionsteil FT3.2.1 als Eingangssignal aufgenommen. Das Ausgangssignal des Funktionsteils FT3.2.1 wird von dem Ausgangssignal des Funktionsteils FT3.2.2 zu einem Ausgangssignal subtrahiert. Dieses Ausgangssignal wird mit einem Ausgangssignal des Funktionsteils FT3.2.3 multipliziert. Das so gebildete Produkt ist das Ausgangssignal des Funktionsteils FT3.2.

Die Summe der Ausgangssignale der Funktionsteile FT3.1 und FT3.2 geht als Eingangssignal in den Funktionsteil FT3.3 ein. Ein Ausgangssignal des Funktionsteils FT3.3 geht neben der Summe aus den Ausgangssignalen der Funktionsteile FT1 und FT2 als zweites Eingangssignal in den Funktionsteil FT4 ein.

Jedes der genannten Ausgangssignale bzw. Summen bzw. Produkt bzw. Differenz wird durch ein separat zugeordnetes Erfassungselement EE überwacht und abgespeichert. So ist eine genaue Überwachung möglich, welche Funktionsteile im Test durchlaufen wurden.

Daher zeigt Fig. 5 zeigt eine Vielzahl an Erfassungselementen EE, die eine genaue Analyse der Abdeckung der Gatteranordnung FPGA bei der Ausführung der Funktion FKT ermöglichen. Insbesondere kann über die Erfassungselemente EE erfasst werden, wie oft die jeweiligen Signale an diesen Stellen geändert wurden. Über die Änderung kann dabei erfasst werden, dass diese Stelle der Gatteranordnung FPGA ausgeführt wurde.

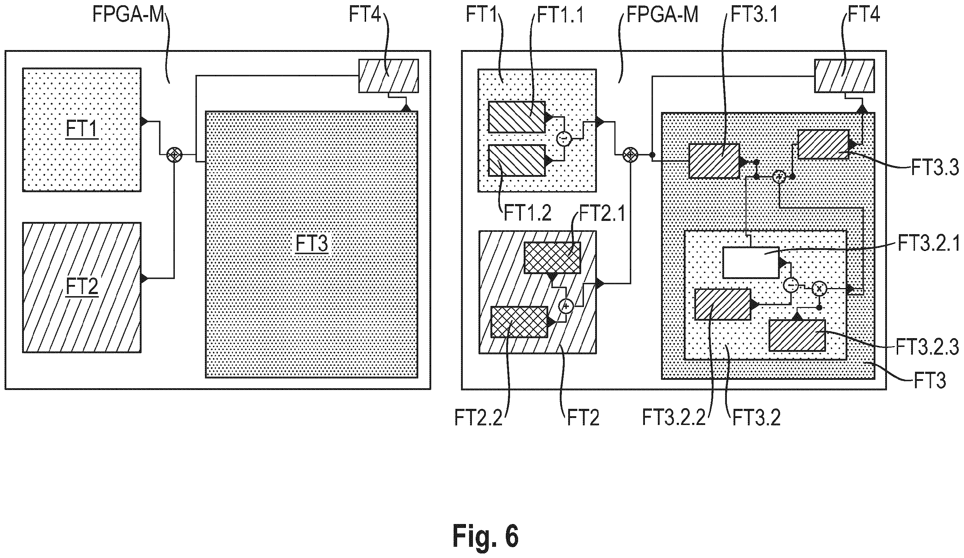

Fig. 6 zeigt in einem Aktivitätsplan (engl. Activity Map) das Modell FPGA-M: Im linken Bild die Funktionen FT1-FT4 aus Fig. 5 auf der obersten Ebene der Funktionsteile FT1-FT4. Das rechte Bild zeigt die Funktionsteile FT1-FT4 wie in Fig. 5 auf Ebenen innerhalb der Funktionsteile FT1-FT4. Je nach Schraffur sind die Funktionsteile FT1.1-FT3.3 unterschiedlich oft durchlaufen worden.

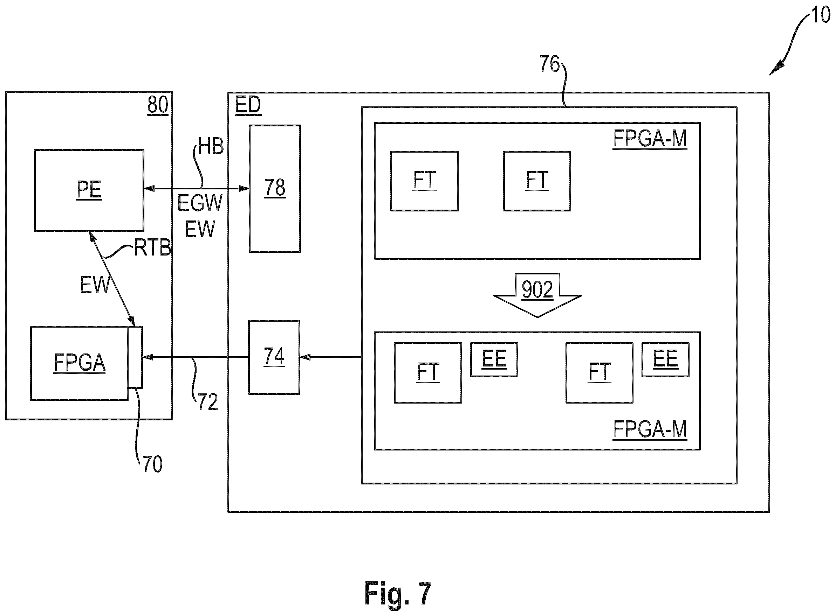

Fig. 7 sieben zeigt in einem Blockschaltbild ein weiteres Ausführungsbeispiel der Rechneranordnung 10 mit der Echtzeitumgebung 80, die die Prozessoreinheit PE sowie die Gatteranordnung FPGA aufweist.

Die Gatteranordnung FPGA weist eine Konfigurationsschnittstelle 70 auf, die Konfigurationsdaten 72 von der Eingabe und Darstellungseinheit ED erhält. Die Konfigurationsdaten 72 werden von einem Erzeugungswerkzeug 74 aus dem Modell FPGA-M generiert. Diese Konfigurationsdaten 72 werden von der Gatteranordnung FPGA zu deren Programmierung genutzt, d.h. damit wird die Funktion FKT, die in den Konfigurationsdaten 72 definiert sind, in der Gatteranordnung FPGA in elektronische Hardware umgesetzt.

Die programmierbare Gatteranordnung FPGA ist ein integrierter Schaltkreis der Digitaltechnik, der sich auf einem Board befindet und in den eine logische Schaltung geladen werden kann. Auf dem Board kann optional auch die Prozessoreinheit PE angeordnet sein. Gemeinsam können die Prozessoreinheit PE und die Gatteranordnung FPGA die Echtzeitumgebung 80 bilden. Mittels der logischen Schaltung kann die Funktion FKT ausgeführt und Signale SIG können verarbeitet werden. Ein Beispiel für die programmierbare Gatteranordnung ist ein Field Programmable Gate Array. Beim Entwurf der programmierbaren Gatteranordnung FPGA kann zunächst auf der Eingabe- und Darstellungseinheit ED ein Modell FPGA-M als Systembeschreibung erstellt werden. Aus dem Modell FPGA-M kann dann mittels Synthese eine Beschreibung auf Logikebene, z. B. in Form einer Netzliste, generiert werden, welche insbesondere eine Beschreibung der Verdrahtung der Schaltung und/oder eine Verknüpfung von Blöcken in Textform erzeugt. Die Blöcke sind Schaltungselement der Gatteranordnung FPGA und umfassen Rechenelemente, Speicherelemente, und/oder Logikschaltungselementen wie bspw. UND-Gattern, ODER-Gattern etc. Mittels des sogenannten Routings wird das sogenannte Design erzeugt, das zusätzlich die Anordnung der Schaltungselemente und des Verlaufs der Verdrahtung auf dem Board erzeugt. Die programmierbare Gatteranordnung FPGA kann dadurch programmiert werden, dass die Konfigurationsdaten, Bitstrom genannt, über die Konfigurationsschnittstelle 70 auf das Board geladen werden. Die Programmierung kann auch als Konfiguration bezeichnet werden. Der Bitstrom ist spezifisch für die Hardware des Boards und wird aus dem Design erzeugt. Nach der Einspeisung des Bitstroms, Programmierung genannt, ist die programmierbare Gatteranordnung FPGA eingerichtet, die Funktion FKT der logischen Schaltung auszuführen und hierzu Signale SIG zu verarbeiten.

Die Konfigurationsschnittstelle 70 ist außerdem über den Echtzeit-Bus RTB mit der Prozessoreinheit PE zur Übertragung der Erfassungswerte EW an die Prozessoreinheit PE verbunden. Dafür weist die Konfigurationsschnittstelle 70 oder die Gatteranordnung FPGA eine Busschnittstelle auf, die die Erfassungswerte EW auf den Bus RTB umsetzt.

Entsprechend empfängt die Prozessoreinheit PE die Erfassungswerte EW über die Busschnittstelle und leitet daraus die Ergebniswerte EGW ab. Die Prozessoreinheit PE überträgt über einen Host-Bus HB die Ergebniswerte EGW und die Erfassungswerte EW. Es ist möglich, dass die Prozessoreinheit PE nur den oder die Ergebniswerte EGW oder nur die Erfassungswerte EW an die Eingabe- und Darstellungseinheit ED überträgt.

Die Eingabe- und Darstellungseinheit ED empfängt die Erfassungswerte EW und/oder die Ergebniswerte EGW über ein Werkzeug zur Entwicklungsunterstützung 78. Darüber kann dann die Darstellung, insbesondere die grafische Darstellung, der Abdeckung erfolgen.

Die Eingabe- und Darstellungseinheit ED weist ein Werkzeug zur Modellerstellung 76 auf. Damit kann bspw. ein Benutzer das Modell FPGA-M mit den Funktionsteilen FT der Funktion FKT erstellen.

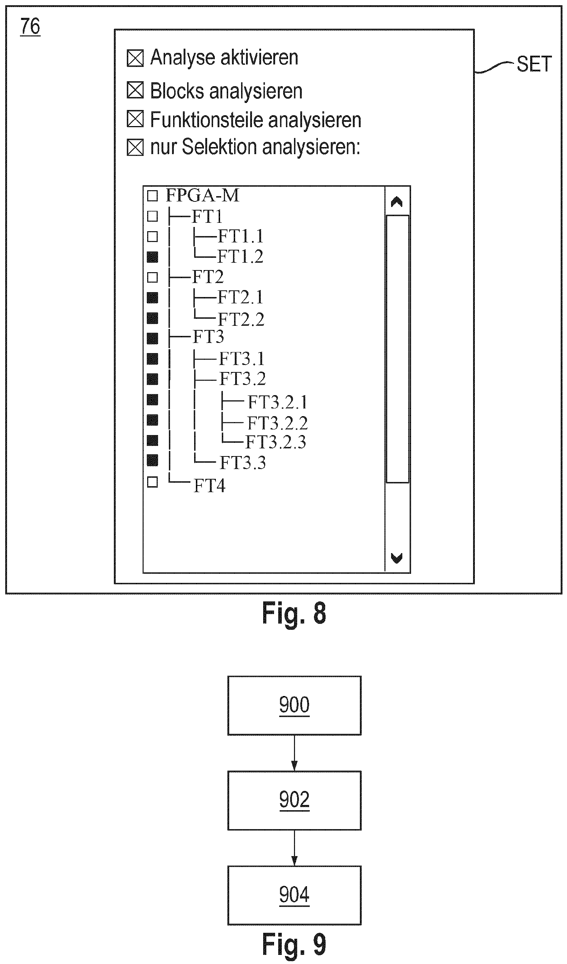

Im Verfahrensschritt 902 (Fig. 9) wird das Modell FPGA-M mit den Funktionsteilen FT um die Erfassungselemente EE ergänzt. Das so fertiggestellte Model FPGA-M dient dann zur Erzeugung der Konfigurationsdaten 72, die über das Erzeugungswerkzeug 74 an die Gatteranordnung FPGA und dort über die Konfigurationsschnittstelle 70 übertragen werden können.

Fig. 8 zeigt ein Beispiel eines Eingabefensters SET des Werkzeugs zur Modellerstellung 76. Die Analyse der Abdeckung kann durch das Eingabefenster SET durch den Nutzer eingestellt werden. Durch ein Aktivieren bestimmter Kästchen kann eingestellt werden, ob und welche Funktionsteile FT des Modells FPGA-M hinsichtlich der Abdeckung erfasst werden sollen. Dies geschieht durch Aktivierung der Kästchen bei z. B. "Analyse aktivieren", "Blocks analysieren", "Funktionsteile analysieren" und/oder "nur Selektion analysieren". Blocks sind elementare Elemente der Gatteranordnung. Ein Funktionsteil FT kann einen oder mehrere Blocks aufweisen. In Fig. 8 sind jeweilige Funktionsteile FT analog zu den Figuren 5 und 6 mit FT1, FT1.1, FT1.2, FT2 ... FT3.3, FT4 bezeichnet.

Durch Aktivieren von Kästchen ist es also möglich, die Funktionsteile FT des Modells FPGA-M auszuwählen, die hinsichtlich der Abdeckung erfasst werden sollen. Bei der Auswahl "nur Selektion analysieren" kann dann durch ein Anklicken der entsprechenden Funktionsteile FT die Test Coverage auf die ausgewählten Funktionsteile FT beschränkt werden.

Entsprechend der Aktivierung der Kästchen erfolgt dann in Schritt 902 ein automatisches Platzieren der Erfassungselemente EE in dem Modell FPGA-M zur Erfassung der Abdeckung.

Fig. 9 zeigt ein Flussdiagramm eines Verfahrens. In Verfahrensschritt 900 werden die Eingabedaten zu dem Modell FPGA-M empfangen, bspw. entweder durch eine Benutzereingabe und/oder von abgespeicherten Daten und/oder von anderen Datenübertragungen.

In Verfahrensschritt 902 erfolgt ein automatisiertes Platzieren zumindest eines Erfassungselements EE in dem Modell FPGA-M. Es kann auch eine manuelle Platzierung der Erfassungselemente EE erfolgen, oder es ist möglich, automatisch platzierte Erfassungselemente EE manuell zu löschen. Auch eine dialoggeführte Platzierung der Erfassungselemente EE ist möglich. Der Dialog kann dabei z. B. unter Verwendung des in Fig. 8 gezeigten Eingabefensters SET erfolgen.

In Verfahrensschritt 904 werden dann die Konfigurationsdaten 72 wie beschrieben aus dem Modell FPGA-M erzeugt und an die Konfigurationsschnittstelle 70 übertragen.

Bei der Ausführung der Funktionsteile FT auf der Gatteranordnung FPGA wird unter Verwendung einer Änderung des Signals SIG ermittelt, ob zumindest ein Funktionsteil FT ausgeführt wird. Dies wird als Erfassungswert EW über das entsprechende Erfassungselement EE bereitgestellt.

### Bezugszeichenliste

- 10: Rechneranordnung
- 32: Verzögerungsglied
- 34: Vergleicher
- FPGA: Gatteranordnung
- FKT: Funktion
- EE, EE1, EE2: Erfassungselement
- EW, EW1, EW2: Erfassungswert
- FT, FT1, FT2, FT3, FT4: Funktionsteil
- SR, SR1, SR2, SR3: Schattenregister
- SIG: Signal
- FPGA-M: Modell
- AL: Ausleselogik
- RTB: Bus
- HB: Host Bus
- PE: Prozessoreinheit
- ED: Eingabe- und Darstellungseinheit
- EGW: Ergebniswert
- CNT: Zähler
- AP: Ausgangsport
- SET: Eingabefenster
- 70: Konfigurationsschnittstelle
- 72: Konfigurationsdaten
- 74: Erzeugungswerkzeug
- 76: Werkzeug zur Modellerstellung
- 78: Werkzeug zur Entwicklungsunterstützung
- 80: Echtzeitumgebung
- EN: Enable-Signal
- 900-904: Verfahrensschritte

## Patentansprüche

1. Programmierbare Gatteranordnung (FPGA), die eingerichtet ist, eine Funktion (FKT) auszuführen und bei der Ausführung der Funktion (FKT) zumindest ein Signal (SIG) durch zumindest einen Funktionsteil (FT) der Funktion (FKT) zu verwenden, wobei die Gatteranordnung (FPGA) zumindest ein Erfassungselement (EE) aufweist, das dazu eingerichtet ist, unter Verwendung einer Änderung des Signals (SIG) zu ermitteln, ob der zumindest eine Funktionsteil (FT) bei der Ausführung der Funktion (FKT) auf der Gatteranordnung (FPGA) ausgeführt wird, und zumindest einen von der Ermittlung abhängigen Erfassungswert (EW) bereitzustellen.

2. Gatteranordnung nach Anspruch 1, die über eine Eingabe eines Modells (FPGA-M) programmierbar ist, wobei das Modell (FPGA-M) die durch die Gatteranordnung (FPGA) ausführbare Funktion (FKT) vorgibt und wobei das Erfassungselement (EE) über das Modell (FPGA-M) auf der Gatteranordnung (FPGA) programmierbar ist.

3. Gatteranordnung nach Anspruch 1 oder 2, wobei die Gatteranordnung (FPGA) eine Ausleselogik (AL) aufweist, die dazu eingerichtet ist, den durch das Erfassungselement (EE) bereitgestellten zumindest einen Erfassungswert (EW) während der Ausführung der Funktion (FKT) oder nach Ende der Ausführung der Funktion (FKT) auszugeben.

4. Gatteranordnung nach Anspruch 3, wobei die Ausleselogik (AL) dazu eingerichtet ist, den zumindest einen Erfassungswert (EW) über eine Multiplexereinheit über einen Bus (RTB) auszugeben oder über eine Schieberregisterkette über einen Bus (RTB) auszugeben.

5. Gatteranordnung nach Anspruch 3, wobei die Ausleselogik (AL) dazu eingerichtet ist, den zumindest einen Erfassungswert (EW) über eine Konfigurationsschnittstelle (70) über einen Bus (RTB) auszugeben, wobei die Konfigurationsschnittstelle (70) dazu eingerichtet ist, Konfigurationsdaten (72) zur Programmierung der Gatteranordnung (FPGA) zu empfangen.

6. Gatteranordnung nach Anspruch 5, wobei das Erfassungselement (EE) zumindest ein Schattenregister zur Aufnahme des zumindest einen Erfassungswerts (EW) aufweist, wobei das zumindest eine Schattenregister (SR1, SR2) einen Speicherbereich aufweist, aus dem der zumindest eine Erfassungswert (EW) unabhängig von der ausgeführten Funktion (FKT) über die Konfigurationsschnittstelle (70) auslesbar ist.

7. Gatteranordnung nach einem der vorhergehenden Ansprüche, wobei das zumindest eine Erfassungselement (EE) zumindest einen Zähler aufweist, über den eine Anzahl an Änderungen des zumindest einen Signals (SIG) erfassbar sind, wobei das zumindest eine Erfassungselement (EE) dazu eingerichtet ist, unter Verwendung der Anzahl an Änderungen des zumindest einen Signals (SIG) zu ermitteln, wie oft der zumindest eine Funktionsteil (FT) bei der Ausführung der Funktion (FKT) auf der Gatteranordnung (FPGA) ausgeführt wird und den zumindest einen Erfassungswert (EW) in Abhängigkeit von der Ermittlung bereitzustellen.

8. Gatteranordnung nach einem der vorhergehenden Ansprüche, wobei das Erfassungselement (EE) das zumindest eine Schattenregister (SR1, SR2) aufweist und dazu eingerichtet ist, vorgegebene Bits des zumindest einen Erfassungswerts (EW) an das zumindest eine Schattenregister (SR1, SR2) zu übertragen.

9. Rechneranordnung (10) aufweisend die Gatteranordnung (FPGA) nach einem der vorhergehenden Ansprüche sowie eine Prozessoreinheit (PE), die dazu eingerichtet ist, den zumindest einen Erfassungswert (EW) zu zumindest einem Ergebniswert (EGW) auszuwerten.

10. Rechneranordnung nach Anspruch 9, wobei der mindestens eine Ergebniswert (EGW) zumindest eine statistische Auswertung mehrerer Erfassungswerte (EW) und/oder mehrerer vom zumindest einen Erfassungswert (EW) abgeleiteter Werte aufweist.

11. Rechneranordnung nach einem der Ansprüche 9 bis 10, weiter aufweisend eine Eingabe- und Darstellungseinheit (ED), die eingerichtet ist, den zumindest einen Erfassungswert (EW) und/oder den zumindest einen Ergebniswert (EGW) auszugeben.

12. Rechneranordnung nach Anspruch 11, wobei über die Eingabe- und Darstellungseinheit (ED) die Eingabe des Modells (FPGA-M) ermöglicht wird, wobei das zumindest eine Erfassungselement (EE) im Modell (FPGA-M) platzierbar ist, wobei die Platzierung manuell und/oder automatisch erfolgt, und wobei die Eingabe- und Darstellungseinheit (ED) dazu eingerichtet ist, in Abhängigkeit vom zumindest einen Ergebniswert (EGW) genutzte Funktionsteile (FT) der Funktion (FKT) der Gatteranordnung (FPGA) darzustellen.

13. Verwendung der Rechneranordnung (10) nach einem der Ansprüche 9 bis 12 zum Testen eines Steuergerätes oder zum Simulieren eines Steuergerätes.

14. Testeinrichtung zum Testen eines Steuergerätes aufweisend eine Rechneranordnung (10) nach einem der Ansprüche 9 bis 12, wobei die Gatteranordnung (FPGA) zum Testen des Steuergeräts über einen Datenaustausch mit dem Steuergerät dient und/oder das Steuergerät mittels der Gatteranordnung (FPGA) simulierbar ist.

15. Verfahren zum Erzeugen von Konfigurationsdaten (72) zur Programmierung einer Gatteranordnung (FPGA) aus einem Modell (FPGA-M), wobei das Modell (FPGA-M) eine durch die Gatteranordnung (FPGA) auszuführende Funktion (FKT) vorgibt, wobei bei der Ausführung der Funktion (FKT) auf der Gatteranordnung (FPGA) zumindest ein Signal (SIG) durch zumindest einen Funktionsteil (FT) der Funktion (FKT) verwendet wird, wobei das Verfahren aufweist
• Empfangen von Eingabedaten zu dem Modell (FPGA-M),
• Automatisiertes Platzieren zumindest eines Erfassungselements (EE) in dem Modell (FPGA-M), wobei das zumindest eine Erfassungselement (EE) dazu eingerichtet ist, bei der Ausführung der Funktion (FKT) auf der Gatteranordnung (FPGA) unter Verwendung einer Änderung des Signals (SIG) zu ermitteln, ob der zumindest eine Funktionsteil (FT) ausgeführt wird, und zumindest einen von der Ermittlung abhängigen Erfassungswert (EW) bereitzustellen.
• Erzeugen der Konfigurationsdaten (72) zur Programmierung der Gatteranordnung (FPGA) aus dem Modell (FPGA-M).
